Europäisches Patentamt

European Patent Office

Office européen des brevets

(19)

(11) Publication number: **0 387 101**
**A2**

# (12) EUROPEAN PATENT APPLICATION

(21) Application number: **90302588.0**

(22) Date of filing: **12.03.90**

(51) Int. Cl.⁵: **G11C 16/04, G11C 16/06**

(30) Priority: **10.03.89 JP 58173/89**

(43) Date of publication of application:
**12.09.90 Bulletin 90/37**

(84) Designated Contracting States:
**DE FR GB**

(71) Applicant: **SEIKO INSTRUMENTS INC.**
**31-1, Kameido 6-chome Koto-ku**
**Tokyo 136(JP)**

Applicant: **AGENCY OF INDUSTRIAL SCIENCE AND TECHNOLOGY**
**3-1, 1-chome, Kasumigaseki**
**Chiyoda-ku Tokyo(JP)**

(72) Inventor: **Hayashi, Yutaka, c/o Agency of Industrial Science**
**and Technology, 1-4 Umezono, 1-chome**
**Tsukuba-shi, Ibaragi(JP)**
Inventor: **Kojima, Yoshikazu**
**c/o Seiko Instruments Inc., 31-1 Kameido, 6-chome**
**Koto-ku, Tokyo(JP)**
Inventor: **Takada, Ryoji**
**c/o Seiko Instruments Inc., 31-1 Kameido, 6-chome**
**Koto-ku, Tokyo(JP)**
Inventor: **Kamiya, Masaaki**
**c/o Seiko Instruments Inc., 31-1 Kameido, 6-chome**
**Koto-ku, Tokyo(JP)**

(74) Representative: **Caro, William Egerton et al**
**J. MILLER & CO. Lincoln House 296-302 High Holborn**
**London WC1V 7JH(GB)**

(54) Semi-conductor non-volatile memory and method of writing the same.

(57) A semi-conductor non-volatile memory comprises one or more integrated memory cells. The or each memory cell comprises a first semi-conductor region (101) having a first surface, an electric charge storage structure (104) disposed on the first surface of the first semi-conductor region for storing electric charge, and a first gate (106) provided to electrically connect to the electric charge storage structure. A second semi-conductor region (121) is electrically connected at one side to the first semi-conductor region (101) and has a second surface. A second gate (126) controls the second surface. A third region (122) is electrically connected to the other side of the second semi-conductor region and a random access potential setting means (131 - 133, 135, 136) is connected to the second gate (126) for setting a potential thereof on a random access basis.

# F I G. 1

## SEMI-CONDUCTOR NON-VOLATILE MEMORY AND METHOD OF WRITING THE SAME

This invention relates to semi-conductor non-volatile memories which can store information even when a power supply is turned off, and to methods of writing such semi-conductor non-volatile memories.

There have been proposed various types of conventional non-volatile memory elements (memory cells) such as MAOS type, FAMOS type, MIOS type, etc. The structure of these memories are different. For example, as an electric charge storage structure for non-volatile storing of logic information in the form of electric charge, an electro-conductive film buried in an electrically insulating layer (i.e. a floating gate) can be used. Alternatively, a multi-layer of dielectric material and a ferro-electric film can be utilised. Further, there have been various injection and extraction methods for selectively injecting and extracting electric charge into and from an electric charge storage structure in order to change the charged state thereof. These methods include avalanche injection, tunnel injection, channel injection and tunnel extraction of electric charge from the electric charge storage structure to change the charged state opposite to the polarity of the extracted electric charge.

The charged state of individual memory cells can be erased concurrently by irradiation by ultra-violet rays or x-rays. Further, by suitable combination of these electric charge injection and extraction methods, one polarity type of electric charge is restored into or extracted from a storage structure, which has stored therein the other polarity type of electric charge, to enable electrical erasing and re-writing of memorised contents. These types of memories are called EAROM and E²PROM.

A semi-conductor region is formed in opposed relation to the electric charge storage structure or an insulating gate region is electrically coupled to the electric charge storage structure for use in feeding electric charge to be injected into the electric charge storage structure and for use in receiving electric charge extracted from the storage structure.

Moreover, in practical IC devices, these various types of non-volatile memory element (memory cell) are combined with a static RAM cell (random access memory). Very recently, it has been proposed in Japanese Patent Application No. 4635/1987 that change of surface potential of a semi-conductor region can be utilised for random access writing or temporary writing prior to non-volatile writing.

This random access writing method is conventionally applied to the non-volatile memory cell.

However, when carrying out random access reading without effecting non-volatile writing, the information is automatically erased. Moreover, the smaller the size of the memory cell, the smaller the read signal and this causes serious drawbacks. Further, according to this conventional method, when a memory cell has a relatively small efficiency of electric charge capture in the storage structure, the signal-to-noise ratio of the signal representative of the contents of the non-volatile memory becomes worse, thereby making it difficult to use commercially.

The present invention seeks to provide a semi-conductor non-volatile memory which can be used as a volatile memory and a non-volatile memory and which can avoid erasure of information even after carrying out random access reading and seeks to provide a method of writing such a non-volatile memory.

According to one aspect of the present invention, there is provided a semi-conductor non-volatile memory comprising one or more integrated memory cells, the or each memory cell being characterised by comprising: a first semi-conductor region having a first surface; an electric charge storage structure disposed on the first surface of the first semi-conductor region for storing electric charge; a first gate provided to electrically connect to the electric charge storage structure; a second semi-conductor region electrically connected at its one side to the first semi-conductor region and having a second surface; a second gate for controlling the second surface; a third region electrically connected to the other side of the second semi-conductor region; and random access potential setting means connected to the second gate for setting a potential thereof on a random access basis.

According to another aspect of the present invention, there is provided a method of writing a semi-conductor non-volatile memory according to the present invention comprising the steps of applying a given potential to the second gate by the random access potential setting means on a random access basis thereby temporarily to write volatile information prior to applying a voltage to the first gate to effect writing of non-volatile information; and thereafter applying concurrently according to a non-volatile writing instruction, a non-volatile writing voltage to the first gate so as to effect non-volatile writing of the temporarily written volatile information into the electric charge storage structure.

According to a further aspect of the present invention, there is provided a semi-conductor non-volatile memory formed on a substrate characterised by comprising: storage means disposed on the substrate for storing electric charge to memorise non-volatile information; injecting means for injecting electric charge into the storage means; supply means for supplying electric charge to the injecting means; volatile control means operable to store temporarily volatile information and interposed between the injecting means and the supply means for controlling flow of electric charge from the supply means to the injecting means according to the volatile information temporarily written in the volatile control means; random access potential setting means for setting a potential of the volatile control means in the random access basis to write volatile information into the volatile control means; and non-volatile control means for controlling the injection of electric charge from the injecting means to the storage means thereby to write thereinto non-volatile information which is representative of the corresponding volatile information written in the volatile control means.

The storage means may comprise a floating gate electrode.

Injecting means may include a semi-conductor region effective to cause a tunnel current to flow between the injecting means and the storage means. Alternatively the injecting means may include a semi-conductor region effective to cause a channel current to flow between the injecting means and the storage means.

The volatile control means may comprise a channel region interposed between the injecting means and the supplying means for regulating the flow of electric charge according to its impedance, and a volatile control gate electrode disposed in opposed relation to the channel region and settable to a potential level representative of the volatile information and effective to control the impedance of the channel region.

The random access setting means may include switching means for effecting random access of the volatile control means. The switching means may be a field effect transistor or a diode.

In each memory cell, the first and second semi-conductor regions may contact directly with each other, or may be electrically connected to a fourth region or channel. In the specification, these relations are expressed by "the first and second semi-conductor regions are electrically connected to each other". In a similar sense, the second and third regions are electrically connected to each other.

The electric charge storage structure can be formed of a multi-layer of dielectric films, an electro-conductive material buried in an insulating layer, or a ferro-electric material. When the electro-conductive material extends horizontally outside the first surface of the first semi-conductor region, the first insulating gate is not necessarily disposed over the surface of the first semi-conductor region, but may be capacitively coupled to the electro-conductive material through an insulating film. Further, in the case where the electric charge storage structure is composed of a multi-layer dielectric material or ferroelectric film, the first gate electrode is disposed on the first surface of the first semi-conductor region through an insulating film or the electric charge storage structure. According to the potential given to the first gate electrode, a potential of the semi-conductor surface of the first semi-conductor region and an electric field of the electric charge storage structure or an electric field of an insulating film in contact with the storage structure can be controlled to effect the injection and extraction of electric charge into and from the electric charge storage structure. Namely, the charged state of the storage structure can be changed.

The expression "electrically coupled" means that the first gate and the electric charge storage structure are capacitively coupled to each other, or that the first gate is constructed to apply an electric field to the electric charge storage structure. The expression "electrically connected second region" means that, when the first semi-conductor region is composed of a channel of the buried type, the second region is a region in ohmic contact with the first semi-conductor region, or that, when an inverted region is formed on the first semi-conductor region, the second region is a region effective to exchange carriers to and from the inverted channel. A fourth region may be interposed between the first and second semi-conductor regions. Further, the third and second regions are also electrically connected to each other. In most cases, the third region is a semi-conductor region. A region composed of metal or silicide may function as the third region.

Further, the random access potential setting means can be composed of a switching element such as a diode or transistor connected to the second gate and functions to set the potential of the second gate according to information to be written and thereafter to maintain temporarily the set potential for a duration. The time needed for setting the potential is far smaller than the time needed for carrying out non-volatile writing. Consequently, information can be quickly set to multi-bits of memory cells just prior to carrying out non-volatile writing. When carrying out non-volatile writing, the volatile or temporary information just sent in multi-bits of memory cells is converted into the corresponding non-volatile information in the storage structure.

The volatile information is written into the second gate by the random access setting means, and then a high voltage is applied to the first gate so as to write the volatile information written in the second gate into the electric charge storage structure as the corresponding non-volatile information in response to impedance of the first and second semi-conductor regions.

The invention is illustrated, merely by way of example, in the accompanying drawings, in which:-

Figure 1 is a sectional view of a first embodiment of a semi-conductor non-volatile memory according to the present invention;

Figures 2 to 4 are sectional views of other embodiments of semi-conductor non-volatile memories according to the present invention;

Figures 5 to 7 are sectional views of semiconductor non-volatile memories according to the present invention, where diodes are used as volatile information setting means; and

Figure 8 is a sectional view of another embodiment of a semi-conductor non-volatile memory according to the present invention.

Throughout the drawings like parts have been designated by the same reference numerals.

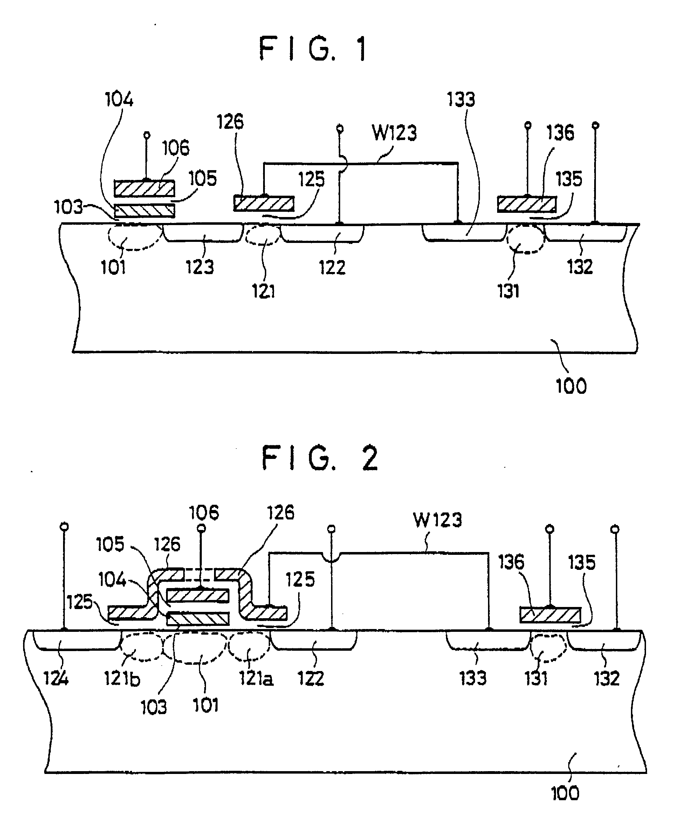

Referring first to Figure 1, there is shown a single cell of a first embodiment of a semi-conductor non-volatile memory according to the present invention. The memory is comprised of a semiconductor substrate 100, a first semi-conductor region 101 of a first conductivity type (for example, P type) and a floating gate 104 made of, for example, polysilicon or an electric charge storage structure composed of, for example, silicon nitride. In Figure 1, the electric charge storage structure 104, e.g. the floating gate, is formed on a surface of the first semi-conductor region 101 through a thin insulating film 103 effective to pass tunnel electrons. A first gate 106 is formed on the electric charge storage structure 104 through an insulating film 105. The first semi-conductor region 101 is electrically connected to a second semi-conductor region 121 of the first conductivity type through a region 123 of the opposite conductivity type. A third region is composed of a semi-conductor region 122 of the opposite conductivity type and is in contact with the second semi-conductor region 121. A second gate 126 is formed on a surface of the second semi-conductor region 121 through an insulating film 125. The second gate 126 operates to control a channel of the opposite conductivity type on the surface of the second semi-conductor region 121.

Random access potential setting means is composed of a field effect transistor comprised of a drain region 132, a source region 133, a channel forming region 131, a gate 136 and a gate insulating film 135. The source region 133 of this random access potential setting means is connected to the second gate 126. Therefore, by applying a positive potential $V_G$ (in the case of an N channel) to the gate 136 and by applying to the drain region 132 a positive potential $V_S$, the second gate 126 is set to the potential level $V_S$ provided that $V_G - V_{TH} > V_S - (V_{TH}$ denotes the threshold voltage of the channel forming region 131). Then, even after re-setting the potential level of the gate 126 to 0 V, the potential of the second gate 136 is held at around $V_S$ within a time interval of discharge in the form of junction leakage current between the regions 133, 131. On the other hand, when the potential of the region 132 is set initially at 0 V, the second gate is held at 0 V for a long time. Accordingly, when the value of $V_S$ is greater than the gate threshold voltage of the second gate 126, the channel on the semi-conductor region 121 is in a low impedance state. Therefore, by holding the potential of the region 122, the potential of the region 123 is accordingly held. When the value of $V_S$ is below the gate threshold voltage of the second gate 126, the surface channel of the semi-conductor region 121 is made a high impedance state. Therefore, the potential of the region 123 is not fixed. Namely, in Figure 1, when volatile information is written into the second gate 126 in the form of the potential level $V_S$ through the random access potential setting means, the impedance of the region 121 is controlled according to the written volatile information. Namely, the volatile information is converted into change of impedance. In this condition, by applying a high voltage to the gate 106, when the channel on the semi-conductor region 121 is in a low impedance state, electrons are injected from the semi-conductor region 101 to the electric charge storage structure 104 through the insulating film 103. At this time, since the low impedance state is maintained during the injection of electrons to the electric charge storage structure 104, the injected electrons are supplied from the region 122 during a programming time. On the other hand, the channel on the surface of the semi-conductor region 121 is held in a high impedance state, the potential of the region 123 is not fixed so that the semi-conductor region 101 is depleted. Therefore, the insulating film 103 is not subjected to a large electric field so that fewer electrons are injected into the storage structure 104. Consequently, by applying a high voltage to the gate 106, the volatile information can be converted into the corresponding non-volatile information in the form of binary data "1" or "0" in an amplified state. Namely, the volatile information which is temporarily written into the second gate 126 through the random access potential setting means is converted into the corresponding non-volatile information in the electric charge storage structure 104 with a logic amplitude greater than that of the volatile information.

When reading out the non-volatile information, while a constant voltage is applied to the gate 106, the charging capacity of the semi-conductor region 101 is monitored. Namely, when the electric charge storage structure 104 has stored few electrons, a relatively large quantity of electrons can be charged into the semi-conductor region 101. On the other hand, when the electric charge storage structure 104 has been injected with a relatively large quantity of electrons, only a relatively small quantity of electrons can be charged into the semi-conductor region 101. The charge can be detected at the region 122 through the field effect transistor having the second gate 126. In this embodiment, since the writing of the non-volatile information utilises the impedance change of the semi-conductor region 121, the logic amplitude of the non-volatile memory can be set greater than the power source voltage.

Figure 2 is a sectional view of a single cell of a second embodiment to a semi-conductor non-volatile memory according to the present invention. The semi-conductor non-volatile memory of Figure 2 is operated to carry out writing in the same manner as that of Figure 1. However, the reading can be carried out statically. The first semi-conductor region 101 is directly connected to a second semi-conductor region 121a without interposing a region such as the region 123 of Figure 1, and an additional region 124 is formed opposite to the third semi-conductor region 122 with respect to the first gate 106. In Figure 2 by applying voltages to the gate electrode 136 and to the drain 132, volatile information can be temporarily written into the second gate 126 in the form of 0 V potential or positive potential $V_S$. By setting the threshold value of the positive potential $V_S$ more than the threshold voltage of the second semi-conductor region 121a, when the potential of the third semi-conductor region 122 is fixed, the surface of the second semi-conductor region 121a is set selectively to a low impedance state and a high impedance state according to the information temporarily written in the gate 126. Thus, when the gate 126 is set to the potential 0 V, the surface of the second semi-conductor region 121a is held at a high impedance state. Accordingly, when the second gate 126 is written with volatile information by the random access potential setting means comprised of the gate and the drain 126, the volatile information is transferred to the second semi-conductor region 121a in the form of the magnitude of the surface impedance. In this condition, by applying a high voltage to the first gate 106, when the surface channel of the region 121a is held in the low impedance state, the first semi-conductor region 101 is accordingly made low impedance. Consequently, electrons supplied from the third region 122 are passed through the surface channel of the second semi-conductor region 121a and the surface channel of the first semi-conductor region 101, and then passed through the thin insulating film 103 to be injected into the electric charge storage structure 104. The injected electrons are continuously supplied from the third region 122 during a writing time interval, because the low impedance state of the surface channel of the region 121a can be maintained as it is even during the course of the injection to the electric charge storage structure 104. On the other hand, in the condition where the second semi-conductor region 121a is in a high impedance state, even if a high voltage is applied to the gate 106, electrons cannot be supplied from the region 122 to the electric charge storage structure 104 because the first semi-conductor region 101 is held in the high impedance state. The expression "semi-conductor region is held low/high impedance" used herein means that the channel built up on the surface of a semi-conductor region is held in a low/high impedance state.

It should be noted that, instead of the above described tunnel injection, channel injection can be utilised to inject electrons from the semi-conductor region 101 to the electric charge storage structure 104. In such a case, unlike that shown in Figure 2, the additional region 124 is directly connected to the semi-conductor region 101 (i.e. a region 121b is eliminated) to provide a modified embodiment of a semi-conductor non-volatile memory according to the present invention. In such an embodiment, by applying a high voltage to the additional region 124, when the first semi-conductor region 101 and the second semi-conductor region 121a are held in the low impedance state, channel hot electrons are generated on the surface of the first semi-conductor region 101 and a part thereof is injected into the electric charge storage structure 104. On the other hand, when the second semi-conductor region 121a is held in the high impedance state, channel hot electrons are not generated on the surface of the semi-conductor region 101 so that no electrons are injected into the electric charge storage structure 104. Thus, by using such channel injection, the volatile information written into the second semi-conductor region 121a is transferred to the electric charge storage structure thereby to program the corresponding non-volatile information.

In Figure 2, the programmed non-volatile information is read in terms of change of impedance between the third region 122 and the additional region 124 as described below. Namely, in the state where a positive voltage is applied to the gate 106 and the gate 126, the second semi-conductor regions 121a, 121b are held in the low impedance state, while the interposed first semi-conductor region 101 has a varying impedance depending on the amount of electrons stored in the electric charge storage structure 104. When a large quantity of electrons are stored, the first semi-conductor region 101 is held in the high impedance state so that the substrate surface is accordingly held in the high impedance state between the region 122 and the additional region 124. On the other hand, when fewer electrons are stored in the electric charge storage structure 104, the first semi-conductor region 101 is held in the low impedance state so that the detected impedance is accordingly low between the regions 122, 124.

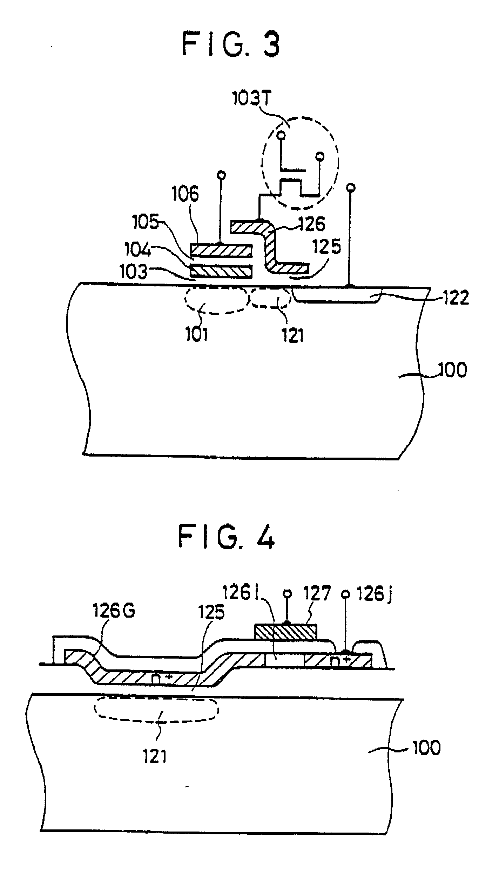

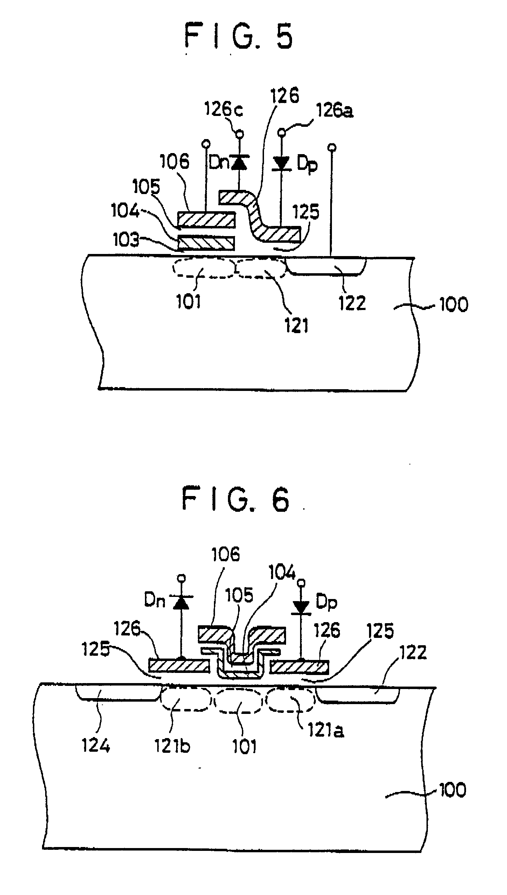

Figure 3 is a sectional view showing a single cell of a third embodiment of a semi-conductor non-volatile memory according to the present invention. In Figure 3, a volatile information input transistor 130T, which operates as the random access potential setting means, is formed on an insulating film disposed on the substrate 1. This volatile information input transistor has the structure shown in Figure 4. A source region 126G and a drain region 126j are formed of polysilicon film or mono-crystalline silicon film. The conduction of a region 126i is controlled by the potential applied to a gate 127 so that a potential level of the drain region 126j is transferred to set the potential of the source region 126G, a part of which constitutes the second gate. The semi-conductor non-volatile memory of Figure 3 operates in a manner similar to that of Figure 1. The volatile information input transistor 103T of Figure 3 can be replaced by diodes $D_p$, $D_n$ shown in Figure 6, which will be described later, to constitute a semi-conductor non-volatile memory which will operate in a manner similar to that of Figure 2.

Figures 5 and 6 are sectional views of memory cells of fourth and fifth embodiments, respectively, of semi-conductor non-volatile memories according to the present invention, in which a diode is provided to function as a random access potential setting means. A pair of diodes $D_n$, $D_p$ are connected to the second gate 126. According to the rectifying function of the diodes $D_n$, $D_p$, the potential level of the second gate 126 can be set in a range from 0 V to $V_S$, i.e. the range between the power source voltage and the forward voltage of the diode so as to write volatile information on a random access basis. The written volatile information is transferred to the electric charge storage structure 104 in the form of the corresponding non-volatile information in a manner similar to that described in relation to Figures 1 and 2. Further, the non-volatile information is read out by detecting the impedance of the semi-conductor region 101.

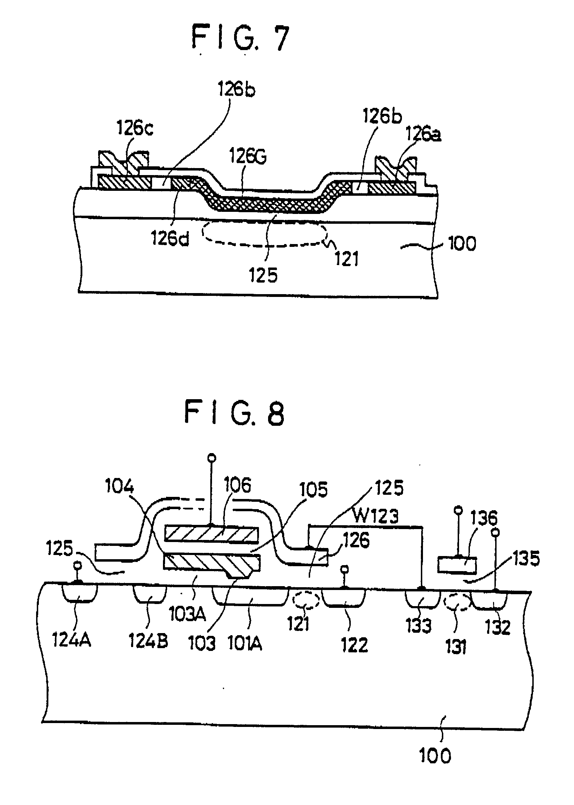

Figure 7 is a sectional view showing the detailed structure of the diodes $D_n$, $D_p$ which function as the random access potential setting means shown in Figures 5 and 6. The diodes are comprised of PN junctions formed in a polysilicon film disposed on a substrate 100. The diode $D_n$ is comprised of $N^+$ type polysilicon film section 126c, N or P type polysilicon film section 126b and $P^+$ type polysilicon film section 126d, and the diode $D_p$ is comprised of $N^+$ type polysilicon film section 126G which constitutes the second gate, N or P type polysilicon film section 126b and $P^+$ type polysilicon film section 126a. In the embodiments of the present invention shown in Figures 3 to 7, the information input transistor and diodes are composed of polysilicon film or single crystal silicon film. The polysilicon film and the single crystal silicon film are continuous or formed commonly with polysilicon film or single crystal silicon film of the second gate. In such a construction, lead patterns can be eliminated between the transistor or diodes and the second gate, thereby reducing the area dimension of each memory cell.

In the aforementioned embodiments of the present invention, the first semi-conductor region is comprised of a channel region. However, the first semi-conductor region is not necessarily limited to the channel region and this is shown in Figure 8. Figure 8 is a section of a memory cell of a further embodiment of a semi-conductor non-volatile memory according to the present invention, in which the first semi-conductor region is composed of $N^+$ type impurity-doped region. The $N^+$ first semi-conductor region 101A is formed in a surface portion of a P type silicon substrate 100. An electric charge storage structure 104 is formed on the region 101A through an insulating film including a thin tunnel insulating film 103. Further, a first gate 106 is formed on the electric charge storage structure 104 through another insulating film 105. Electric charge storage structure 104 functions to control conductance of a channel between an $N^+$ type impurity doped region and a first semi-conductor region 101A on the surface of the semi-conductor substrate 100. Further, the first semi-conductor region 101A is electrically connected to the second semi-conductor region 121, which is electrically connected to the third region 122 of $N^+$ type conductivity. The second gate 126 is formed on the second semi-conductor region 121 through the gate oxide film 125. Further, the second gate 126 is connected to the random access potential setting means in the form of a transistor comprised of the source region 133, the drain region 132, the channel region 131, the gate electrode 136 and the gate insulating film 135.

The semi-conductor non-volatile memory of Figure 8 operates in a manner similar to the embodiment shown in Figures 1 to 7. Namely, when the second gate 126 is set by the random access potential setting means to a potential level effective to increase conductance of the second semi-conductor region 121, the potential level of the first semi-conductor region 101A is fixed to the potential level of the $N^+$ type impurity doped region 122.

Consequently, for example, if the region 122 is set to the potential level of 0 V, the potential level of the first semi-conductor region 101A is accordingly made 0 V. Thus, by applying a positive high voltage to the first gate 106, tunnel current flows through the thin tunnel insulating film 103 so that electrons are injected into the electric charge storage structure from the first semi-conductor region 101A. On the other hand, when the second gate 126 is set by the random access potential setting means to another potential effective to decrease the conductance of the second semi-conductor region 121, the potential level of the first semi-conductor region 101A is floated so that electric charge is not supplied to the semi-conductor region 101A even upon application of the high voltage to the first gate 106. In summary, the random access potential setting means is operated on a random access basis to set the potential of the second gate 126 thereby to program or write the volatile information in each memory cell. Then, the volatile information is converted concurrently into the corresponding volatile information in the electric charge storage structure of each cell throughout the semi-conductor non-volatile memory thereby to program the information.

Further, in reading out the programmed non-volatile information, when a constant voltage is applied to the first gate 106, the value of the channel conductance is detected between the $N^+$ type impurity doped region 124B and the first semi-conductor region 101A.

In erasing the written non-volatile information, an electrical method can be used in place of irradiation by ultra-violet rays. Namely, a high voltage is applied to the $N^+$ type impurity doped region 122 and to the second gate 126 and a voltage of 0 V is applied to the first gate. Consequently, a high electric field is applied to the tunnel insulating film 103 on the first semi-conductor region 101A so that electrons stored in the electric charge storage structure 104 is drawn to the first semi-conductor region 101A thereby to erase the non-volatile information. In Figure 8 there is provided the $N^+$ type impurity doped region 124A, but the region 124A and a portion of the second gate 126 disposed between the region 124A and the region 124B may be eliminated to reduce further the area dimension of each memory cell.

In the above described embodiment, it should be noted that the first and second semi-conductor regions can be formed directly on the surface portion of the semi-conductor substrate, or can be formed in an opposite conductivity type well formed in the substrate, or can be formed in a semi-conductor film disposed on an insulating film.

In the above described embodiments, electric charge is injected into the electric charge storage structure from the surface of the first semi-conductor region. However, the injection can be effected from the first gate. Further, electric charge can be drawn from the electric charge storage structure to the first gate or the first semi-conductor region.

Moreover, in constructing memory cells into a matrix array of memory, word lines are connected to the gate of the transistor of each random access potential setting means and bit or data lines are connected to the drain of each transistor so as selectively to write volatile information into each memory cell. In reading out the non-volatile information, the first gate is connected to the word line and the third region is connected to the bit line. According to the array construction, the drain of the transistor of the random access potential setting means can be made common to the third region.

As described above, according to the present invention, a semi-conductor non-volatile memory is comprised of random access potential setting means composed of a diode or a transistor, and means for converting the volatile information written by the random access potential setting means into the corresponding non-volatile information in the electric charge storage structure. The construction of the memory cell is rather simple to facilitate construction of multi-bit memories. Thus, the volatile information is written at high speed, and the volatile information is concurrently programmed into the corresponding non-volatile information at respective memory cells of an array. Further, the volatile information is written in the form of impedance change, and this impedance change is amplified during the conversion into the corresponding non-volatile information, thereby achieving the effect of stable programming and reading of the non-volatile information.

## Claims

1. A semi-conductor non-volatile memory comprising one or more integrated memory cells, the or each memory cell being characterised by comprising: a first semi-conductor region (101; 101A) having a first surface; an electric charge storage structure (104) disposed on the first surface of the first semi-conductor region for storing electric charge; a first gate (106) provided to electrically connect to the electric charge storage structure (104); a second semi-conductor region (121; 121a, 121b) electrically connected at its one side to the first semi-conductor region (101, 101A) and having a second surface; a second gate (126; 126G) for controlling the second surface; a third region (122) electrically connected to the other side of the second semi-conductor region (121); and random access potential setting means (131 - 133, 135, 136; 130T; $D_n$, $D_p$) connected to the second gate (126; 126G) for setting a potential thereof on a random access basis.

2. A method of writing a semi-conductor non-volatile memory as claimed in claim 1 characterised by: applying a given potential to the second gate (126; 126G) by the random access potential setting means (131 - 133, 135, 136; 130T; $D_n$, $D_p$) on a random access basis thereby temporarily to write volatile information prior to applying a voltage to the first gate (126; 126G) to effect writing of non-volatile information; and thereafter applying concurrently according to a non-volatile writing instruction, a non-volatile writing voltage to the first gate (106) so as to effect non-volatile writing of the temporarily written volatile information into the electric charge storage structure (104).

3. A semi-conductor non-volatile memory formed on a substrate (100) characterised by comprising: storage means (104) disposed on the substrate for storing electric charge to memorise non-volatile information; injecting means (121) for injecting electric charge into the storage means; supply means for supplying electric charge to the injecting means; volatile control means (126) operable to store temporarily volatile information and interposed between the injecting means and the supply means for controlling flow of electric charge from the supply means to the injecting means according to the volatile information temporarily written in the volatile control means; random access potential setting means (131 - 133, 135, 136; 130T; $D_n$, $D_p$) for setting a potential of the volatile control means in the random access basis to write volatile information into the volatile control means; and non-volatile control means (106) for controlling the injection of electric charge from the injecting means to the storage means (104) thereby to write thereinto non-volatile information which is representative of the corresponding volatile information written in the volatile control means.

4. A semi-conductor non-volatile memory as claimed in claim 3 characterised in that the storage means comprises a floating gate electrode (104).

5. A semi-conductor non-volatile memory as claimed in claim 3 or 4 characterised in that the injecting means includes a semi-conductor region (121) effective to cause a tunnel current to flow between the injecting means and the storage means.

6. A semi-conductor non-volatile memory as claimed in claim 3 or 4 characterised in that the injecting means includes a semi-conductor region (124) effective to cause a channel current to flow between the injecting means and the storage means.

7. A semi-conductor non-volatile memory as claimed in any of claims 3 to 6 characterised in that the volatile control means comprises a channel region interposed between the injecting means and the supplying means for regulating the flow of electric charge according to its impedance, and a volatile control gate electrode (126) disposed in opposed relation to the channel region and settable to a potential level representative of the volatile information and effective to control the impedance of the channel region.

8. A semi-conductor non-volatile memory as claimed in any of claims 3 to 7 characterised in that the random access setting means includes switching means (130T) for effecting random access of the volatile control means.

9. A semi-conductor non-volatile memory as claimed in claim 8 characterised in that the switching means comprises a field effect transistor.

10. A semi-conductor non-volatile memory as claimed in claim 8 characterised in that the switching means comprises a diode ($D_n$, $D_p$).

# FIG. 1

# FIG. 2

# FIG. 3

# FIG. 4

# F I G. 5

# F I G. 6

# F I G. 7

# F I G. 8